# EUROPÄISCHE PATENTSCHRIFT

(11) **EP 4 068 349 B1**
(45) Veröffentlichungstag und Bekanntmachung des Hinweises auf die Patenterteilung: **20.09.2023**
(21) Anmeldenummer: 21165837.2
(22) Anmeldetag: 30.03.2021
(51) Int. Cl.: H01L 23/00, H01L 23/04, H01L 23/34, H01L 23/053, H01L 25/07, H01L 23/60, G01K 1/14, G01K 1/16, G01K 7/42, G06F 1/18, G06F 1/20, H01L 23/40, H02M 1/32, H02M 7/00

(54) **LEISTUNGSMODUL**
POWER MODULE
MODULE DE PUISSANCE

(43) Veröffentlichungstag der Anmeldung: 05.10.2022
(73) Patentinhaber: Siemens Aktiengesellschaft, 80333 München (DE)
(72) Erfinder: Jonas, Stephan, 92431 Neunburg (DE); Reichenbach, Norbert, 92224 Amberg (DE); Trottmann, Jürgen, 95685 Falkenberg (DE)
(74) Vertreter: Siemens Patent Attorneys

(56) Entgegenhaltungen:
- EP-A2- 2 506 300
- DE-A1- 10 024 516
- DE-A1-102007 052 630
- Anonymous: "AN2009-10 - Using the NTC inside a power electronic module - Considerations regarding temperature measurement", , 1. November 2009 (2009-11-01), Seiten 1-10, XP055841552, Warstein, Germany Gefunden im Internet: URL:https://www.infineon.com/dgdl/Infineon -AN2009_10_Using_the_NTC-ApplicationNotes- v01_00-EN.pdf?fileId=db3a304325afd6e001262 8b593e62233 [gefunden am 2021-09-15]

## Beschreibung

Die Erfindung betrifft ein Leistungsmodul.

Zur Steuerung elektrischer Energieflüsse werden leistungselektronische Module, auch Leistungsmodule genannt, eingesetzt. Leistungsmodule enthalten unter anderem Halbleiter, mit denen der Strom- und damit der Energiefluss geeignet beeinflusst wird. Die Ströme und Spannungen bewegen sich typischerweise im Bereich von 1 bis 2000 Ampere und 40 bis 1500 V.

Die Leistungsmodule befinden sich in der Regel in einem elektrischen Gerät mit Ein- und Ausgängen, über die die elektrische Energie ein- und austritt. Ebenfalls in diesem Gerät befindet sich üblicherweise eine Steuereinheit, welche die Ansteuerung der Halbleiter der Leistungsmodule und weitere gerätespezifische Steuer- und Schutzfunktionen übernimmt. Beispiele für derartige elektrische Geräte sind elektronische Motorsteuergeräte, welche als Halbleiter Thyristoren einsetzen oder Umrichter zum Steuern von elektrischen Motoren, bei denen als Halbleiter typischerweise IGBT (= Insulated-Gate Bipolar Transistor) und Thyristoren verwendet werden. Die Gesamtheit der elektrischen Elemente, Halbleiter und Verbindungen, durch die der elektrische Energiefluss hindurchtritt, wird als Hauptstromkreis bezeichnet.

Die Halbleiter der Leistungsmodule werden bei der Steuerung des elektrischen Stromes infolge der dabei in den Halbleitern entstehenden elektrischen Verluste warm und können, z. B. wenn die Stromwerte zu hoch werden oder die Kühlung des Geräts beeinträchtigt ist, Temperaturwerte erreichen, die ihre Funktion einschränken oder sie gar zerstören. Zum Schutz der Halbleiter wird deshalb in den Leistungsmodulen ein temperaturempfindliches Bauelement eingebracht, mit dem die Temperatur der Halbleiter genähert erfasst werden kann. Das temperaturempfindliche Bauelement wird im Weiteren auch als Temperatursensor bezeichnet.

Die vom Temperatursensor gemessene Temperatur bzw. eine der Temperatur entsprechende elektrische Größe wird in der Regel der Steuereinheit übergeben, die beim Überschreiten vorgegebener Temperaturgrenzwerte geeignete Steuersignale an die Halbleiterelemente zu deren Schutz sendet.

Da in aller Regel die Steuereinheit elektrisch isoliert vom Hauptstromkreis ausgebildet ist, ist auch der mit der Steuereinheit verbundene Temperatursensor im Leistungsmodul elektrisch isoliert zu den Halbleitern angeordnet. Diese elektrische Isolation wird durch einen räumlichen Abstand des Temperatursensors zu den Halbleitern in Kombination mit einer elektrisch isolierenden Vergussmasse erreicht.

Dabei wird, unter Einhaltung der Erfordernisse der elektrischen Isolation, aus den folgenden Gründen eine räumlich möglichst nahe Anordnung des Temperatursensors zu den Halbleitern angestrebt. Zum einen ist die Temperaturmessung der Halbleiter umso genauer, je kleiner der räumliche Abstand zwischen dem Temperatursensor und den Halbleitern ist. Zum anderen erfordert der generelle Trend hin zu hohen Leistungsdichten und damit zu kleinen Bauvolumen eine möglichst kompakte Anordnung der Halbleiterelemente und des Temperatursensors innerhalb des Leistungsmoduls.

Aufgrund von Fehlfunktionen oder äußeren Störungen, wie z. B. einem Kurzschluss auf der Ausgangsseite des Geräts, kann in den Halbleitern ein sehr hoher Stromfluss zu Stande kommen, der weit über dem zulässigen Wert der Halbleiter oder der anderen stromdurchflossenen Teile des Leistungsmoduls liegt. Dieser sehr hohe Stromwert führt in der Regel zum Verdampfen elektrisch leitfähiger Teile innerhalb des Leistungsmoduls.

Das dabei entstehende Plasma breitet sich innerhalb des Leistungsmoduls explosionsartig aus und führt zu starken Zerstörungen innerhalb des Leistungsmoduls. Als Folge der Ausbreitung des Plasmas kann es im Extremfall zu einer kurzen oder auch dauerhaften, fehlerhaften elektrischen Verbindung zwischen Teilen des Hauptstromkreis und dem Temperatursensor und damit zur Steuereinheit kommen. Die hohe Spannung des Hauptstromkreises tritt dann auf die Steuereinheit über. Da die Steuereinheit in der Regel auf dem gleichen, in Normalfall ungefährlich niedrigen, Spannungspotential wie die Bedienebene liegt, muss dieser Spannungsübertritt durch entsprechende Maßnahmen unbedingt vermieden werden.

Zusammenfassend kann man also festhalten, dass die Halbleiter eines Leistungsmoduls vor zu hohen Temperaturen geschützt werden sollen. Für einen guten Schutz, d. h. eine möglichst genaue Temperaturmessung, muss ein Temperatursensor räumlich möglichst nahe bei den Halbleitern angeordnet sein, womit gleichzeitig die Forderung nach einem kompakten Aufbau erfüllt wird. Der räumlichen Kompaktheit entgegen steht die Forderung, dass der Temperatursensor, der auf dem Spannungsniveau der Bedienebene liegt, elektrisch vom hohen Spannungsniveau der Halbleiter getrennt werden muss und diese Trennung auch für die Extremsituation eines Kurzschlusses gewährleistet sein muss.

Eine Lösung zur Trennung der Spannungsniveaus besteht darin, den räumlichen Abstand zwischen den Halbleitern und dem Temperatursensor ausreichend groß zu machen, so dass im Kurzschlussfall eine elektrische Verbindung zwischen dem Hauptstromkreis und der Steuereinheit nicht auftreten kann. Dies macht das Leistungsmodul aber größer und teurer, engt also die Möglichkeit der Herstellung kompakter Geräte mit höherer Leistungsdichte ein und verringert die Genauigkeit der Temperaturmessung. Ein Beispiel zeigt das linke Bild "NTC inside the EconoDUAL^{™} 3 mounted on a separate DCB dose to the IGBT" in Kapitel 2 "Internal Design" der Infineon Application Note AN2009-10 "Using the NTC inside a power electronic module", V1.0, Nov. 2009, Edition 2010-01-13, Infineon Technologies AG, 59568 Warstein, Germany.

Eine andere Lösung besteht darin, Sicherungselemente vorzusehen, die den Hauptstromkreis vor einer Beschädigung im Kurzschlussfall schützen. Sicherungselemente bedeuten erhöhte Kosten und Aufwand; außerdem werden sie im Betrieb sehr warm, was z. B. beim Schaltschrankbau zu einem Mehraufwand für Kühlung führt.

Eine weitere Lösung ist, auf einen im Leistungsmodul integrierten Temperatursensor zu verzichten und diesen stattdessen als ein separates Bauteil mit einem eigenen Gehäuse, d. h. als einen externen Temperatursensor, auszuführen, so dass ein Kurzschluss im Hauptstromkreis keine Auswirkungen auf den Temperatursensor hat. Ein kompakter Aufbau ist dadurch nur eingeschränkt möglich, die Genauigkeit der Temperaturmessung ist nicht optimal und es entstehen zusätzliche Kosten für den externen Temperatursensor durch das eigene Gehäuse, die separate Montage und den Anschluss. Ein solcher externer Temperatursensor ist beschrieben in EP1568978A1 (Siemens AG) 31. August 2005.

Eine ebenfalls zum Einsatz kommende Lösung stellt die zusätzliche elektrische Trennung des Temperatursensors von der Steuereinheit dar. Hierbei wird davon ausgegangen, dass, z. B. als Folge eines Kurzschlusses, der Temperatursensor auf dem gleichen elektrischen Potential liegt wie der Hauptstromkreis. Die notwendige elektrische Trennung erfolgt dabei in der Regel innerhalb der Steuereinheit, z. B. mit einem Optokoppler, der das temperaturanaloge Signal des Temperatursensors über eine optische Trennstrecke auf die Spannungsebene der Steuereinheit umsetzt. Neben dem Aufwand an elektrischen Bauteilen zur Beschaltung des Optokopplers müssen auch räumliche Abstände im Bereich des elektrisch trennenden Optokopplers eingehalten werden, die einen größeren Platzbedarf auf der Leiterplatte, auf welcher die elektronischen Bauteile untergebracht sind, erfordern. Neben den zusätzlichen Kosten für den Optokoppler und dessen elektronische Beschaltung wirkt sich dies nachteilig auf die Kompaktheit der Steuereinheit aus und kann zu einer Gerätevergrößerung führen. Im rechten Bild "NTC inside a module without baseplate, mounted close to the silicon" in Kapitel 2 "Internal Design" der oben erwähnten Infineon Application Note AN2009-10 ist ein Temperatursensor gezeigt, der nahe bei den Halbleitern angeordnet ist. In diesem Fall kann es notwendig sein, den Temperatursensor, wie eben beschrieben, elektrisch von der Steuereinheit zu trennen. Entsprechende Betrachtungen zur Isolation sind im Abschnitt 2.1 "Isolation considerations" der oben erwähnten Infineon Application Note AN2009-10 angeführt.

DE 100 24 516 A1 (EUPEC GMBH & CO KG [DE]; SIEMENS AG [DE]) 29. November 2001 (2001-11-29) beschreibt ein Leistungshalbleitermodul mit einem Leistungsbauteil und einem Sensorikbauteil. Dabei kann das Sensorikbauteil einen Sensor aufweisen, der zur Überwachung der Temperatur des Leistungsbauteils dient. Das Leistungsbauteil ist auf einem Substrat vorgesehen. Das Sensorikbauteil ist mit einem zusätzlichen, gesonderten Substrat versehen, das neben und/oder auf dem Substrat des Leistungsbauteils angeordnet ist, so dass zwischen dem Leistungsbauteil und dem Sensorikbauteil eine doppelte elektrische und mechanische Isolation besteht. Dabei kann das zusätzliche, gesonderte Substrat ein Gehäuseelement umfassen, welches den Sensor einschließt. Durch die mechanische Isolation des Sensorikbauteils vom Leistungsbauteil wird das Sensorikbauteil für den Fall einer Havarie mechanisch gegen sich ablösende Modulbestandteile, z. B. im Fall einer Explosion, geschützt, so dass auch im Havariefall die Aufnahme und Fortleitung von Messwerten durch das Sensorikbauteil gewährleistet ist.

Es ist deshalb die Aufgabe der vorliegenden Erfindung, ein Leistungsmodul anzugeben, bei dem der Temperatursensor thermisch eng an den oder die Halbleiter gekoppelt ist und trotzdem elektrisch vom hohen Spannungsniveau der Halbleiter getrennt ist, auch im Fehlerfall.

Diese Aufgabe wird gemäß einem ersten Aspekt der Erfindung durch ein Leistungsmodul gemäß dem unabhängigen Anspruch 1 gelöst. Diese Aufgabe wird gemäß einem zweiten Aspekt der Erfindung durch ein Leistungsmodul gemäß dem unabhängigen Anspruch 2 gelöst. Vorteilhafte Ausgestaltungen der erfindungsgemäßen Leistungsmodule sind Gegenstand der abhängigen Ansprüche.

Das Leistungsmodul weist ein Gehäuse auf. Das Gehäuse weist eine Trägerplatte, Gehäusewände und einen Gehäusedeckel auf. Dabei fungiert die Trägerplatte als eine Bodenplatte des Gehäuses. Das Gehäuse weist einen Innenraum auf, der durch die Trägerplatte, die Gehäusewände und den Gehäusedeckel eingehaust ist. Das Leistungsmodul weist Halbleiterelemente auf, die im Inneren des Gehäuses auf der Trägerplatte angeordnet sind. Das Leistungsmodul weist eine Temperatursensoreinheit auf, die im Inneren des Gehäuses auf der Trägerplatte angeordnet ist. Dabei weist die Temperatursensoreinheit einen Temperatursensor auf. Das Leistungsmodul weist außerdem Trennwände auf, die im Inneren des Gehäuses die Temperatursensoreinheit von den Halbleiterelementen abtrennen und in einer Kammer einschließen. Diese Trennwände bilden um die Temperatursensoreinheit eine Kammer, die die Temperatursensoreinheit, die mit der Spannungsebene der Steuereinheit verbunden ist, vom restlichen Bereich des Leistungsmoduls, welcher zur Spannungsebene des Hauptstromkreises gehört, weitgehend abschließt.

Die Erfindung basiert auf der Idee, dass durch eine einfache konstruktive Maßnahme, nämlich mithilfe zusätzlicher Trennwände im Inneren eines bestehenden Gehäuses eines Leistungsmoduls, der Temperatursensor der Temperatursensoreinheit thermisch eng an das oder die Halbleiterelemente gekoppelt bleibt und die Temperatursensoreinheit trotzdem elektrisch vom hohen Spannungsniveau der Halbleiterelemente getrennt ist, auch im Fehlerfall. Der Temperatursensor kann somit räumlich nahe bei den Halbleitern angeordnet sein, womit gleichzeitig die Forderung nach einem kompakten Aufbau erfüllt wird. Gleichzeitig wird die Temperatursensoreinheit, die auf dem Potential der Bedienebene liegt, durch die Trennwände elektrisch vom hohen Spannungsniveau der Halbleiter getrennt, wobei diese Trennung auch für die Extremsituation eines Kurzschlusses gewährleistet ist. Dabei wird die Wandstärke der Trennwände so gewählt, dass eine ausreichende Abschirmwirkung bzw. mechanische Belastbarkeit der Trennwand gewährleistet ist. Dabei wird die Wandstärke an die Leistungsfähigkeit bzw. Stromstärke eines Leistungsmoduls, und damit an die Kurzschlussanforderungen und die Zerstörwirkungen, angepasst.

Die Erfindung ist ohne großen Aufwand zu realisieren: Der Aufwand beschränkt sich im Wesentlichen auf konstruktive Maßnahmen beim Gehäuse des Leistungsmoduls, die bei einer Neuentwicklung keine oder nur minimale zusätzliche Kosten erzeugen. Die Kompaktheit des Leistungsmoduls und damit eines Geräts, in welchem das Leistungsmodul eingebaut ist, bleibt erhalten, da die vorgeschlagene Lösung geringe Abstände zwischen den Halbleitern des Hauptstromkreises und der Temperatursensoreinheit ermöglicht und somit keinen nennenswerten zusätzlichen Platzbedarf erfordert. Die Genauigkeit der Temperaturmessung ist wegen der geringen Abstände zwischen Halbleitern und Temperatursensor hoch. Zusätzliche mit Zeit und Kosten verbundene Maßnahmen in einer Gerätefirmware zur Verbesserung der Genauigkeit sind nicht notwendig.

Gemäß einer bevorzugten Ausführungsform der Erfindung sind die Trennwände mit dem Gehäusedeckel verbunden und bilden mit dem Gehäusedeckel ein Bauteil. Das hat den Vorteil, dass die Trennwände beim Aufsetzen des Gehäusedeckels auf die Gehäusewände im Inneren des Gehäuses positioniert werden.

Gemäß einer bevorzugten Ausführungsform der Erfindung sind die Trennwände als ein separates Bauteil ausgebildet, das im Inneren des Gehäuses auf der Trägerplatte angeordnet ist. Dabei wird das kammerartige Bauteil über den Temperatursensor gesetzt, bevor der Gehäusedeckel montiert wird. Da die äußeren Abmessungen des Leistungsmoduls durch die Trennwände nicht verändert werden, sondern erhalten bleiben, kommt die Verwendung eines separaten, als Kammer ausgeführten Bauteils auch für bereits bestehende Leistungsmodule in Frage und ist eine relativ einfache Nachrüstmöglichkeit, da am Gehäusedeckel keine Änderungen vorgenommen werden müssen; somit lässt sich auf relativ einfache Weise das Verhalten eines bereits eingesetzten Leistungsmoduls im Kurzschlussfall verbessern.

Gemäß dem ersten Aspekt der Erfindung verringert sich die Wandstärke der Trennwände an ihrer unteren, zur Trägerplatte zeigenden Kante. Das hat den Vorteil, dass die Trennwände, die bis bzw. fast bis zur Trägerplatte reichen, die Stärke der Vergussmasse in dem Bereich der verringerten Wandstärke nur so weit verringern, dass sich eine elektrisch isolierende Vergussmasse, mit der die elektrischen Bauteile des Leistungsmoduls zum Schutz vor Umwelteinflüssen und zur elektrischen Isolation umhüllt werden, noch in ausreichender Stärke ausbilden kann.

Eine verringerte Wandstärke der Trennwände an ihrer unteren, zur Trägerplatte zeigenden Kante kann auch den Vorteil aufweisen, dass durch die damit einhergehende relative kleine Auflagefläche der Trennwände auf der Trägerplatte ein Druck auf die Trennwände von oben, z. B. durch das Aufsetzen eines Gehäusedeckels, zu einer relativ hohen Flächenpressung und somit einem lückenlosen Anschmiegen der unteren, zur Trägerplatte zeigenden Kante der Trennwände an die Trägerplatte führt. Somit werden Lufteinschlüsse zwischen der Unterkante der Trennwand und der Trägerplatte, die zu einer Verschlechterung einer Isolationswirkung der Trennwand führen könnten, vermieden.

Gemäß einer bevorzugten Ausführungsform des ersten Aspekts der Erfindung reichen die Trennwände mit ihrer unteren, zur Trägerplatte zeigenden Kante bis an die Trägerplatte heran oder bilden lediglich einen schmalen Durchgangsspalt zwischen den Trennwänden und der Trägerplatte aus.

Gemäß dem zweiten Aspekt der Erfindung bilden die Trennwände mit ihrer unteren, zur Trägerplatte zeigenden Kante lediglich einen schmalen Durchgangsspalt zwischen den Trennwänden und der Trägerplatte aus. Das hat den Vorteil, dass die durch die Trennwände gebildete Kammer so stabil ist, dass sie durch Auswirkungen eines Kurzschlusses in dem Leistungsmodul nicht zerstört wird. Dabei wird die Spalthöhe des Durchgangsspalts so gewählt, dass eine in das Innere des Gehäuses eingefüllte elektrisch isolierende Vergussmasse noch durch den Durchgangsspalt fließen kann, aber gleichzeitig die Abschirmwirkung und mechanische Belastbarkeit der Trennwand nicht wesentlich geschwächt wird.

Der Durchgangsspalt (zweiter Aspekt der Erfindung) und die reduzierte Wandstärke (erster Aspekt der Erfindung) hängen miteinander zusammen und resultieren aus dem unter Umständen sehr knappen Platz im Leistungsmodul zur Unterbringung des Temperatursensors bei den gleichzeitigen Anforderungen an elektrische Isolation und mechanischer Festigkeit. Würde man in einem Fall, bei dem der Abstand zwischen Leiterflächen, auf denen die Halbleiterelemente aufgebracht sind, und einer Leiterbahn, auf der die Temperatursensoreinheit aufgebracht ist, nur geringfügig größer als die Trennwanddicke ist, die Trennwand in voller Dicke bis zur Trägerplatte nach unten ziehen, wäre das für die mechanische Festigkeit der Kammer zwar vorteilhaft, es bliebe aber zwischen den Leiterflächen und der Trennwand nur ein relativ schmaler Spalt, in den der Verguss einfließen muss, um seine Funktion als elektrischer Isolator erfüllen zu können. Gleiches gilt für die andere Seite der Trennwand, die zur Kammer zeigt: auch hier bliebe nur ein relativ schmaler Spalt zwischen der Trennwand und der Leiterbahn, auf der die Temperatursensoreinheit aufgebracht ist. Die beiden durch die Trennwand gebildeten Spalte können dabei so schmal sein, dass man aus fertigungstechnischer Sicht nicht sicherstellen kann, dass die Vergussmasse sich in diesen Spalten ausreichend dick und damit ausreichend elektrisch isolierend ausbildet.

Hinzu kommt, dass der verbleibende Durchgangsspalt zwischen der Unterkante der Trennwand und der Trägerplatte so schmal sein kann, dass keine Vergussmasse in den Durchgangsspalt fließen kann, so dass dort Luft verbleiben würde. Luft hat aber deutlich schlechtere Isolationseigenschaften als die Vergussmasse. Man müsste also damit rechnen, dass die Kombination aus sehr schmalen Spalten und Lufteinschluss nicht ausreichend isolationsfest ist. Aus diesem Grund ist es von Vorteil, die Trennwanddicke im Berührbereich zur Trägerplatte hin zu reduzieren. Die verbleibenden Eckbereiche werden dadurch wesentlicher breiter und die Vergussmasse kann sich sicher auf beiden Seiten der Trennwand in einer ausreichenden Dicke für eine Isolationswirkung ausbilden.

Um die Gefahr eines Lufteinschlusses zwischen der Unterkante der Trennwand und der Trägerplatte zu vermeiden, der zu einem Isolationsversagen führen könnte, muss aber sichergestellt werden, dass zwischen der Unterkante der Trennwand und der Trägerplatte Vergussmasse einfließen kann, was erfordert, den Durchgangsspalt h ebenfalls ausreichend groß zu machen. Die reduzierte Dicke d der Trennwand hängt damit mit der erforderlichen Spalthöhe h des Durchgangsspalts zusammen: je größer die reduzierte Dicke d der Trennwand gewählt wird, desto größer muss auch die Spalthöhe h des Durchgangsspalts gewählt werden.

Gemäß einer bevorzugten Ausführungsform der Erfindung weisen die Gehäusewände mindestens eine Seitenwand und/oder Längswand auf, die im Vergleich zu den restlichen Gehäusewänden eine geringere Wanddicke aufweist, so dass sie im Falle eines erhöhten Drucks im Inneren des Gehäuses als eine Sollbruchstelle fungieren kann. Auf diese Weise wird die Stabilität der Kammer des Temperatursensors im Vergleich zur Stabilität des restlichen Leistungsmoduls erhöht. Bei einem Kurzschluss im Bereich der Halbleiter streben die explosionsartig entstehenden Gase im ersten Augenblick nach allen Seiten weg. Diese Druckwelle breitet sich dann in Richtung des geringsten mechanischen Widerstandes aus, so dass zuerst die mindestens eine verdünnte Seitenwand und/oder die mindestens eine verdünnte Längswand dem Druck nachgeben und bersten, bevor die die Kammer der Temperatursensoreinheit bildenden Trennwände angegriffen werden. Mit dem vollständigen oder auch teilweisen Erhalt der mechanischen Integrität der Kammer der Temperatursensoreinheit kann ein Spannungsübertritt von der Hauptstromkreisseite auf die Steuereinheit vermieden werden.

Gemäß einer bevorzugten Ausführungsform der Erfindung weist das Leistungsmodul zwei oder mehr Halbleiterelemente auf, zwischen denen die Temperatursensoreinheit angeordnet ist. Das hat den Vorteil, dass die Genauigkeit der Temperaturmessung wegen der geringen Abstände zwischen den Halbleitern und dem Temperatursensor relativ hoch ist.

Gemäß einer bevorzugten Ausführungsform der Erfindung weist die Temperatursensoreinheit elektrische Leitungen zur Versorgung des Temperatursensors auf. Von Vorteil ist hierbei, dass Bauteile, die auf dem Potential der Bedienebene liegen, gemeinsam in der Kammer angeordnet und von dem Potential des Hauptstromkreises getrennt sind.

Gemäß einer bevorzugten Ausführungsform der Erfindung weist die Temperatursensoreinheit eine auf der Trägerplatte liegende Leiterbahn auf, welche eine elektrische Zuleitung zu dem Temperatursensor bildet. Von Vorteil ist hierbei, dass Bauteile, die auf dem Potential der Bedienebene liegen, gemeinsam in der Kammer angeordnet und von dem Potential des Hauptstromkreises getrennt sind.

Gemäß einer bevorzugten Ausführungsform der Erfindung weisen die Trennwände mindestens eine Öffnung auf, welche einen Verbindungskanal zwischen der Kammer und dem restlichen Innenraum des Gehäuses bildet, durch den eine elektrisch isolierende Vergussmasse in die Kammer hineinfließen kann. Das hat den Vorteil, dass der Temperatursensor durch die elektrisch isolierende Vergussmasse vor Umwelteinflüssen geschützt und zur elektrischen Isolation umhüllt werden kann.

Gemäß einer bevorzugten Ausführungsform der Erfindung ist mindestens eine der Trennwände zwei- oder mehrschichtig ausgebildet. Das hat den Vorteil, dass die mechanische Stabilität einer mehrschichtigen Wand gegenüber einer einschichtigen Wand gleicher Dicke erhöht sein kann.

Die oben beschriebenen Eigenschaften, Merkmale und Vorteile dieser Erfindung sowie die Art und Weise, wie diese erreicht werden, werden klarer und deutlicher verständlich durch die folgende Beschreibung der Zeichnungen. Hierbei zeigen in schematischer und nicht maßstabsgetreuer Darstellung:
- FIG 1: eine Schrägansicht einer Trägerplatte eines Leistungsmoduls;
- FIG 2: einen Längsschnitt II-II des Leistungsmoduls von FIG 1;
- FIG 3: einen Querschnitt III-III des Leistungsmoduls von FIG 1;
- FIG 4: eine Schrägansicht eines Horizontalschnitts IV-IV des Leistungsmoduls von FIG 1;
- FIG 5: eine Draufsicht des Horizontalschnitts IV-IV des Leistungsmoduls von FIG 1;
- FIG 6: bis 9 Schnitte einer Trennwand gemäß vier unterschiedlichen Ausgestaltungen;
- FIG 10: und 11 zwei Ausführungen von mehrschaligen Trennwänden; und
- FIG 12: bis 14 eine weitere Ausgestaltung eines Leistungsmoduls mit einem separaten Kammer-Bauteil.

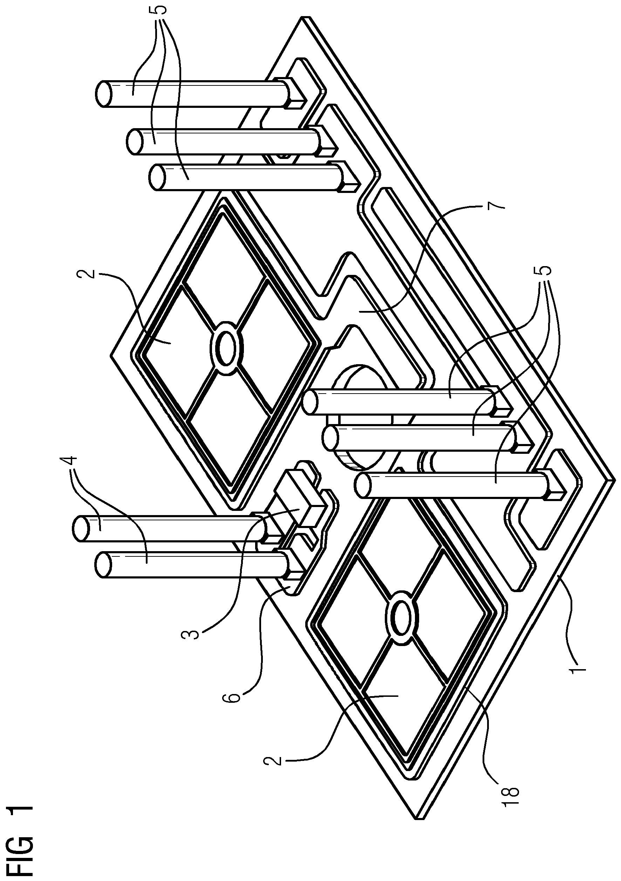

FIG 1 zeigt eine Trägerplatte 1 eines Leistungsmoduls, auf welcher zwei Halbleiterelemente 2 und ein Temperatursensor 3 angeordnet sind. Ebenfalls sind die als säulenförmige Anschlussstifte ausgebildeten elektrischen Leitungen 4, 5 dargestellt, die auf der Trägerplatte 1 liegende Leiterbahnen 6, 7 der Trägerplatte 1 kontaktieren. Die Leiterbahnen 6, 7, die vorzugsweise als Kupferbahnen ausgebildet sind, bilden die elektrischen Zuleitungen zu den beiden Halbleiterelementen 2 und dem Temperatursensor 3. Dabei sind die Halbleiterelemente 2 auf Leiterflächen 18 angeordnet, die auf der Trägerplatte 1 liegen und als Kupferflächen ausgebildet sind.

Auf der Trägerplatte 1 existieren zwei Bereiche, die zu unterschiedlichen Spannungsebenen gehören. Zum einen sind die beiden Halbleiterelemente 2, die sie kontaktierenden Leiterbahnen 7 und die diese Leiterbahnen 7 berührenden elektrischen Leitungen 5 (Anschlussstifte) Teil der Spannungsebene des Hauptstromkreises, zum anderen gehören der Temperatursensor 3 mit seinen Leiterbahnen 6 und den zugehörigen elektrischen Leitungen 4 (Anschlussstiften) zur Spannungsebene einer Steuereinheit, in der eine wesentliche geringere Spannung herrscht als im Hauptstromkreis.

Der Temperatursensor 3 befindet sich zwischen den beiden Halbleiterelementen 2 und hat zu diesen nur einen geringen Abstand. Durch die Platzierung des Temperatursensors 3 zwischen den beiden Halbleiterelementen 2 vergrößert sich der Platzbedarf auf der Trägerplatte 1 nicht, so dass das Leistungsmodul sehr kompakt gehalten werden kann. Außerdem ist der geringe Abstand zwischen dem Temperatursensor und den beiden Halbleiterelementen vorteilhaft für die Genauigkeit der Temperaturmessung.

Die räumliche Nähe zwischen den beiden Halbleiterelementen 2 und dem Temperatursensor 3 erfordert Maßnahmen, um den Temperatursensor 3 im Falle eines Kurzschlusses im Hauptstromkreis, der zu explosionsartigen Verdampfungsvorgängen und damit Zerstörungen im Bereich der Halbleiterelemente 2 führen kann, vor den Kurzschlussauswirkungen zumindest soweit zu schützen, dass ein kurzer oder auch dauernder Spannungsübertritt von der Spannungsebene des Hauptstromkreises auf die Spannungsebene des Temperatursensors 3 und damit der Steuereinheit verhindert wird.

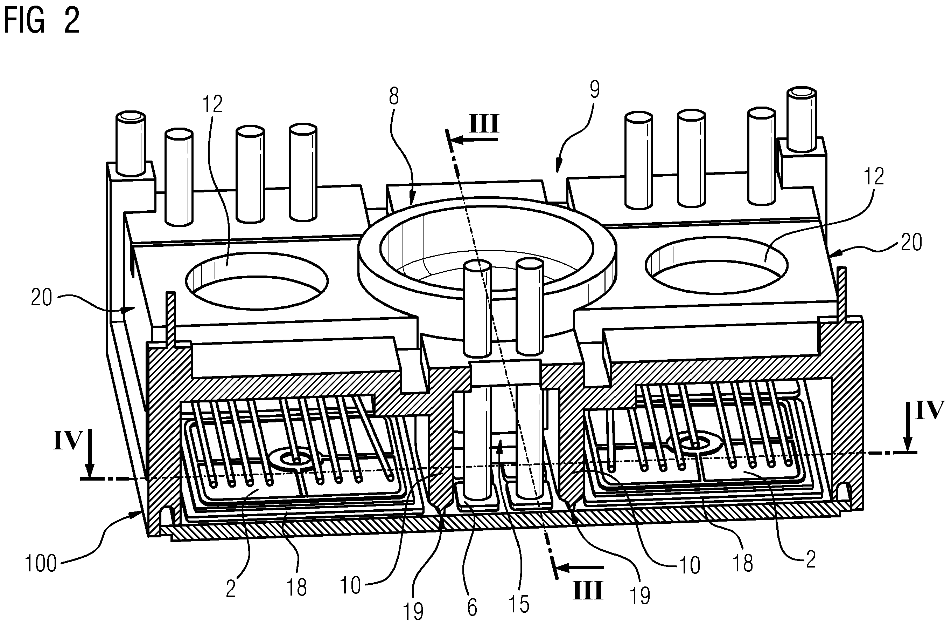

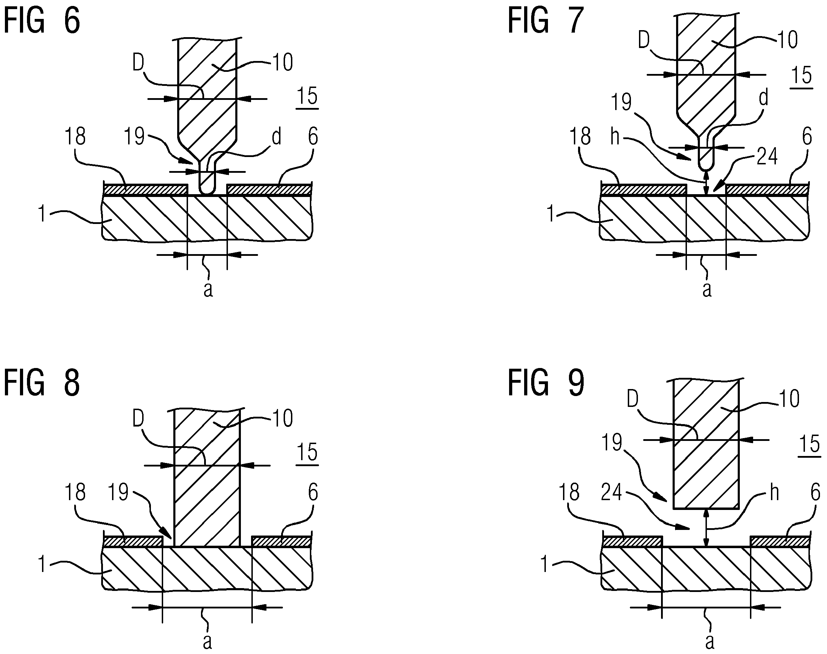

FIG 2 bis 5 veranschaulichen, wie zur Lösung dieser Aufgabe der Temperatursensor 3 erfindungsgemäß durch konstruktive Maßnahmen räumlich vom Bereich des Hauptstromkreises abgetrennt ist. Hierzu sind am Gehäusedeckel 8 des Gehäuses 100 des Leistungsmoduls 9 Wände angebracht, die im Inneren des Gehäuses 100, gebildet durch die den Gehäuseboden bildende Trägerplatte 1, den Gehäusedeckel 8 und die sich zwischen Trägerplatte 1 und Gehäusedeckel 8 erstreckenden Gehäusewände 11, als Trennwände 10 fungieren. Durch diese Trennwände 10 wird um die Temperatursensoreinheit 3, 4, 6, bestehend aus dem Temperatursensor 3, die ihn kontaktierende Leiterbahnen 6 und die zugehörigen elektrischen Leitungen 4, eine Kammer 15 errichtet, die die Temperatursensoreinheit, die mit der Spannungsebene der Steuereinheit verbundenen ist, vom restlichen Bereich des Leistungsmoduls 9, welches zur Spannungsebene des Hauptstromkreises gehört, weitgehend abschließt. Die Trennwände 10 sind so tief ausgeführt, dass sie beim Aufsetzen des Gehäusedeckels 8 auf die Gehäusewände 11 bis an die Trägerplatte 1 heranreichen, wie in FIG 6 und 8 dargestellt, oder zumindest nur einen Durchgangsspalt 24 der Spalthöhe h hin zur Trägerplatte 1 lassen, wie in FIG 7 und 9 dargestellt. Dabei ist die Spalthöhe h so gewählt, dass die Vergussmasse noch durch den Durchgangsspalt 24 fließen kann, aber gleichzeitig die Abschirmwirkung und mechanische Belastbarkeit der Trennwand 10 nicht wesentlich geschwächt wird. Typische Spalthöhen können in einem Bereich von 0,1 bis 3 mm liegen; diese Werte sind nur beispielhaft, aber in keiner Weise einschränkend zu verstehen; der Durchgangsspalt 24 kann auch jede andere Spalthöhe h aufweisen, die sich für den jeweiligen Anwendungsfall als geeignet erweist.

Der Gehäusedeckel 8 weist Einfüllöffnungen 12 zum Einfüllen einer Vergussmasse sowie ein Durchgangsloch 22 auf, das sich vertikal durch eine mittig im Leistungsmodul 9 angeordnete Säule 23 erstreckt. Das Durchgangsloch 22 dient dem Zweck, eine Schraube durchführen zu können, damit das Leistungsmodul 9 an einen Kühlkörper angepresst werden kann.

Die Trennwände 10 weisen, wie in FIG 6 bis 9 dargestellt, eine für ihre Funktion als Explosionsschutz ausreichend dicke Wandstärke D auf und werden so an die vorhandenen Gehäusewände 11 und den Gehäusedeckel 8 angebunden, dass eine stabile Kammer 15 um die Temperatursensoreinheit 3, 4, 6 herum entsteht. Typische Wandstärken können in einem Bereich von 0,5 bis 5 mm liegen; diese Werte sind nur beispielhaft, aber in keiner Weise einschränkend zu verstehen; die Trennwände 10 können auch jede andere Wandstärke D aufweisen, die sich für den jeweiligen Anwendungsfall als geeignet erweist. Die Stabilität der Kammer 15 ist ausreichend groß, so dass sie durch die Kurzschlussauswirkungen nicht oder nur soweit zerstört wird, dass ein Spannungsübertritt von der Spannungsebene des Hauptstromkreises auf die der Temperatursensoreinheit 3, 4, 6 verhindert werden kann.

Zum Schutz vor Umwelteinflüssen und zur elektrischen Isolation werden die elektrischen Bauteile eines Leistungsmoduls mit einer elektrisch isolierenden Vergussmasse umhüllt. Dieser wird durch eine der beiden Einfüllöffnungen 12 im Gehäusedeckel 8, die in FIG 2 gezeigt sind, eingefüllt, bis eine vorgegebene Füllhöhe 16 erreicht ist, die sicherstellt, dass alle elektrisch leitfähigen Teile im Inneren des Leistungsmoduls 9 umhüllt sind, so dass die elektrische Isolierung und der Schutz vor Umwelteinflüssen erreicht wird.

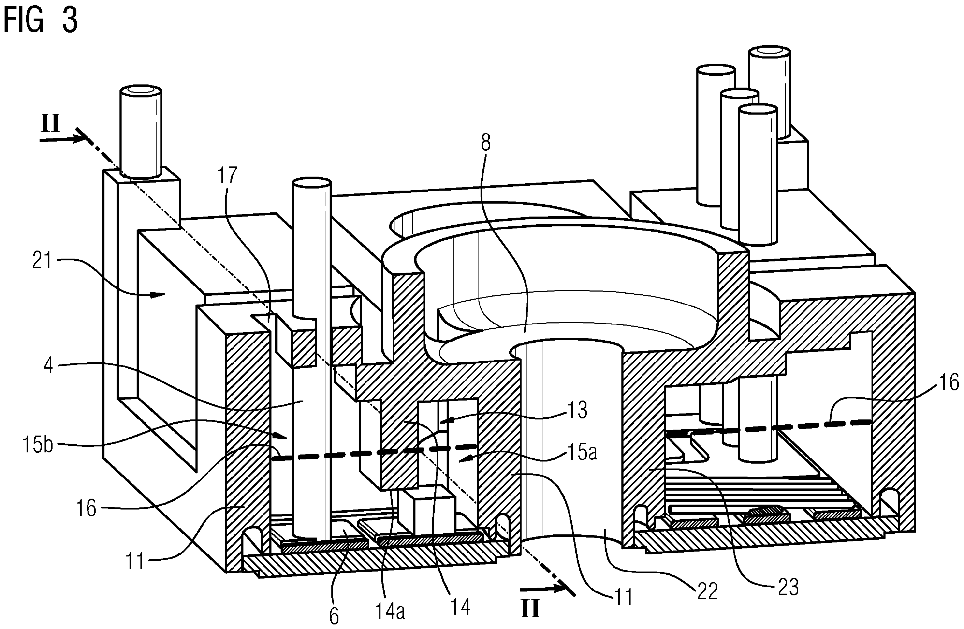

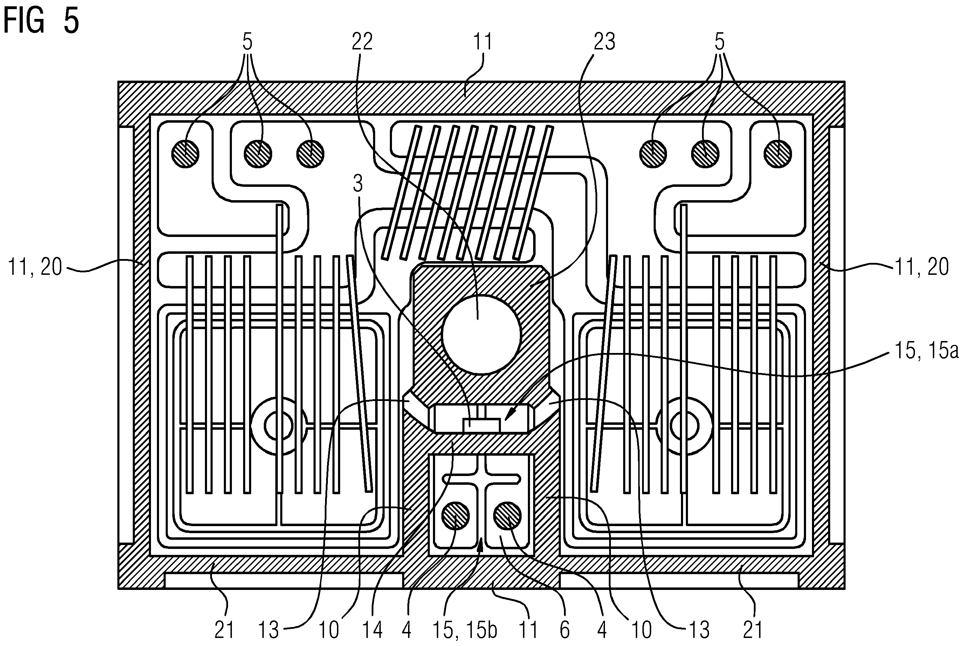

Damit die Vergussmasse auch in die Kammer der Temperatursensoreinheit eintreten kann, sind Verbindungskanäle 13, die in FIG 3 und 5 gezeigt sind, in die Trennwände 10 eingebracht. Aus Kostengründen und aus technischen Gründen wird die Vergussmasse nicht bis zur Unterkante des Gehäusedeckels 8 aufgefüllt. Bei einer vollständigen Verfüllung können bei Temperaturänderungen infolge thermischer Ausdehnung der Vergussmasse Druckkräfte auf den Gehäusedeckel 8 und die Trägerplatte 1 wirken, die zu einem Abheben des Gehäusedeckels 8 von der Trägerplatte 1 führen und damit die elektrische Isolationseigenschaften des Leistungsmoduls 9 beeinträchtigen können.

Um zu verhindern, dass im Kurzschlussfall elektrisch leitfähige Gase, die durch die Verbindungskanäle 13 der Kammer 15 eintreten können, die elektrischen Leitungen 4 des Temperatursensors 3 erreichen und damit einen Spannungsübertritt von der Hauptstromseite auf die Spannungsebene der Steuereinheit bewirken, werden die elektrischen Leitungen 4 mit einer zusätzlichen Wand 14 abgetrennt, welche die Kammer 15 in eine Hauptkammer 15a, in der der Temperatursensor 3 angeordnet ist, und eine halboffene Unterkammer 15b, in der die elektrischen Leitungen 4 angeordnet sind, trennt. Die zusätzliche Wand 14 ist, wie in FIG 3 gezeigt, nur so tief ausgeführt, dass die verbleibende Öffnung zwischen der Unterkante 14a der zusätzlichen Wand 14 und der Trägerplatte 1 ausreichend groß ist, so dass die Vergussmasse auch in die Unterkammer 15b fließen kann und somit alle Bereiche der Trägerplatte 1 innerhalb der Kammer 15 bedeckt. Auf diese Weise sind auch in der Unterkammer 15b die Leiterbahnen 6 vollständig und die elektrischen Leitungen 4 teilweise umhüllt und damit elektrisch isoliert. Damit die Vergussmasse auch in der Unterkammer 15b bis zur vorgesehenen Füllhöhe 16, die in FIG 3 gestrichelt eingezeichnet ist, ansteigen kann, ist im Gehäusedeckel 8 eine Entlüftungsöffnung 17 eingebracht.

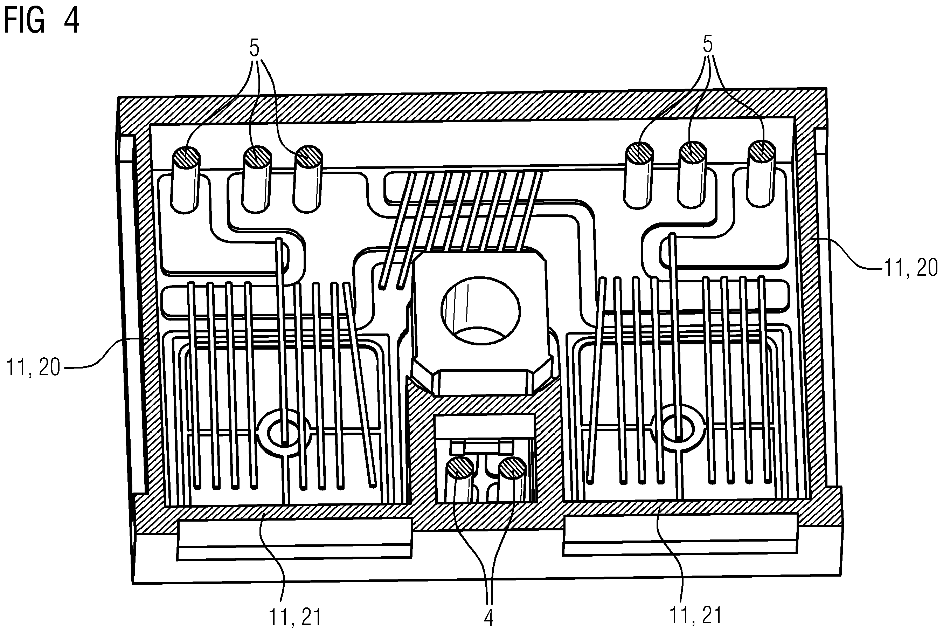

Als weitere Maßnahme zur Vermeidung eines Spannungsübertritts von der Spannungsebene des Hauptstromkreises auf die Spannungsebene der Steuereinheit, können z. B. Seitenwände 20 der Gehäusewände 11 und Längswände 21 der Gehäusewände 11 in bestimmten Bereichen verdünnt ausgeführt werden, wie in FIG 4 und 5 gezeigt. Auf diese Weise wird die Stabilität der Kammer 15 der Temperatursensoreinheit 3, 4, 6 im Vergleich zur Stabilität des restlichen Leistungsmoduls 9 erhöht. Bei einem Kurzschluss im Bereich der Halbleiterelemente 2 streben die explosionsartig entstehenden Gase im ersten Augenblick nach allen Seiten weg. Diese Druckwelle breitet sich dann in Richtung des geringsten mechanischen Widerstandes aus, so dass zuerst die verdünnten Seitenwände 20 und die verdünnte Längswand 21 dem Druck nachgeben und bersten, bevor die Trennwände 10 der Temperatursensoreinheit 3, 4, 6 angegriffen werden. Mit dem vollständigen oder auch teilweisen Erhalt der mechanischen Integrität der Kammer 15 der Temperatursensoreinheit 3, 4, 6 kann ein Spannungsübertritt vom Hauptstromkreis auf die Steuereinheit vermieden werden.

FIG 6 bis 9 zeigen Schnitte einer Trennwand gemäß vier unterschiedlichen Ausgestaltungen. Wegen der räumlichen Kompaktheit des Leistungsmoduls 9 kann der Abstand a zwischen den Leiterflächen 18, auf denen die Halbleiterelemente 2 aufgebracht sind und der Leiterbahn 6 der Temperatursensoreinheit 3, 4, 6 relativ gering sein, wie in FIG 2 erkennbar. Die elektrische Isolation zwischen den Leiterflächen 18 der Halbleiterelemente 2, die zur Spannungsebene des Hauptstromkreises gehören und der Leiterbahn 6 der Temperatursensoreinheit 3, 4, 6, die zur Spannungsebene der Steuereinheit gehören, wird durch die Vergussmasse erreicht, welche die Leiterbahn 6 und die Leiterflächen 18 bedeckt. Damit die Vergussmasse ihre elektrische Isolationsfunktion erfüllen kann, muss die Schichtdicke der Vergussmasse eine Mindestdicke aufweisen. Typische Schichtdicken der Vergussmasse können in einem Bereich von 0,5 bis 5 mm liegen; dieser Wert ist nur beispielhaft, aber in keiner Weise einschränkend zu verstehen; die Vergussmasse kann auch jede andere Schichtdicke aufweisen, die sich für den jeweiligen Anwendungsfall als geeignet erweist. Damit die Trennwände 10, die bis bzw. fast bis zur Trägerplatte 1 reichen, die Stärke der Vergussmasse im Bereich der senkrechten Kanten der Leiterbahn 6 und der Leiterfläche 18 nicht unzulässig verringern, können die Trennwände 10, wie in FIG 6 und 7 dargestellt, an ihrer unteren Kante 19 auf eine Dicke d verdünnt sein, so dass sich die Vergussmasse in den Eckbereichen, begrenzt von der Leiterbahn 6 bzw. Leiterfläche 18, der Trägerplatte 1 und der Trennwand 10, noch in ausreichender Stärke ausbilden kann. Dabei zeigt FIG 6 eine Ausführung, bei der die verdünnte Kante 19 auf der Trägerplatte 1 anliegt; FIG 7 zeigt dagegen eine Ausführung, bei der zwischen der verdünnten Kante 19 und der Trägerplatte 1 ein Durchgangsspalt 24 mit einer Spalthöhe h ausgebildet ist, in den die Vergussmasse einfließen kann.

Typische verringerte Wandstärken d können in einem Bereich von 0,2 bis 3 mm liegen; diese Werte sind nur beispielhaft, aber in keiner Weise einschränkend zu verstehen; die Trennwände 10 können auch jede andere verringerte Wandstärke d aufweisen, die sich für den jeweiligen Anwendungsfall als geeignet erweist.

Falls der Abstand a zwischen den Leiterflächen 18, auf denen die Halbleiterelemente 2 aufgebracht sind und der Leiterbahn 6 der Temperatursensoreinheit 3, 4, 6 ausreichend groß ist, ist es nicht nötig, die Wandstärke der Trennwände 10 an ihrer unteren Kante 19 zu verringern; stattdessen können die Trennwände 10 über ihre gesamte Höhe eine einheitliche Dicke D aufweisen, wie in FIG 8 und 9 dargestellt. Dabei zeigt FIG 8 eine Ausführung, bei der die Kante 19 der Trennwand 10 auf der Trägerplatte 1 anliegt; FIG 7 zeigt dagegen eine Ausführung, bei der zwischen der verdünnten Kante 19 und der Trägerplatte 1 ein Durchgangsspalt 24 mit einer Spalthöhe h ausgebildet ist, in den die Vergussmasse einfließen kann.

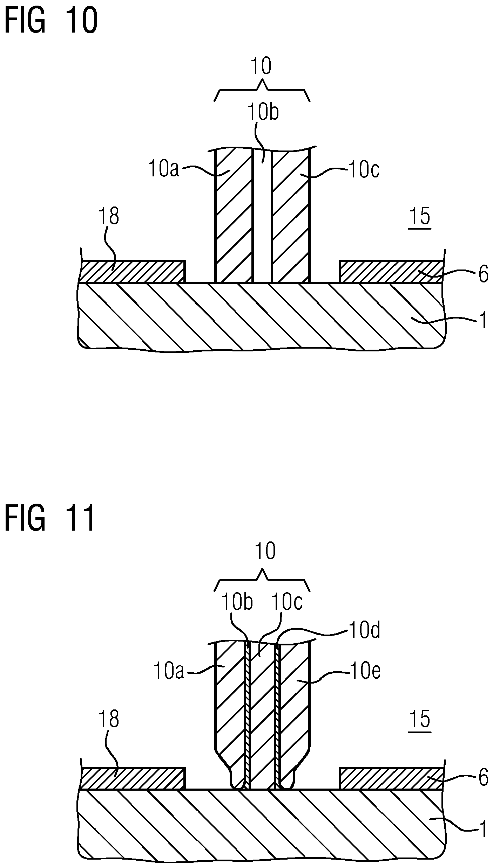

FIG 10 und 11 illustrieren zwei Ausführungen von mehrschaligen Trennwänden.

FIG 10 zeigt einen dreischaligen Aufbau einer Trennwand 10, bestehend aus einer ersten Außenschale 10a, welche auf der von der Kammer 15 abgewandten Seite der Trennwand 10 angeordnet ist, einer zweiten Außenschale 10c, welche auf der der Kammer 15 zugewandten Seite der Trennwand 10 angeordnet ist, und einer Zwischenschale 10b, welche als eine Luftschicht ausgebildet ist.

FIG 11 zeigt einen fünfschaligen Aufbau einer Trennwand 10, aufweisend eine erste Außenschale 10a, welche auf der von der Kammer 15 abgewandten Seite der Trennwand 10 angeordnet ist, eine zweite Außenschale 10e, welche auf der der Kammer 15 zugewandten Seite der Trennwand 10 angeordnet ist, und eine Mittelschale 10c, welche zwischen den beiden Außenschalen 10a und 10e angeordnet ist. Zwischen den Außenschalen 10a, 10e und der Mittelschale 10c ist jeweils eine Verbindungsschicht 10b bzw. 10d angeordnet, welche z. B. als eine Klebstoffschicht ausgebildet sein kann.

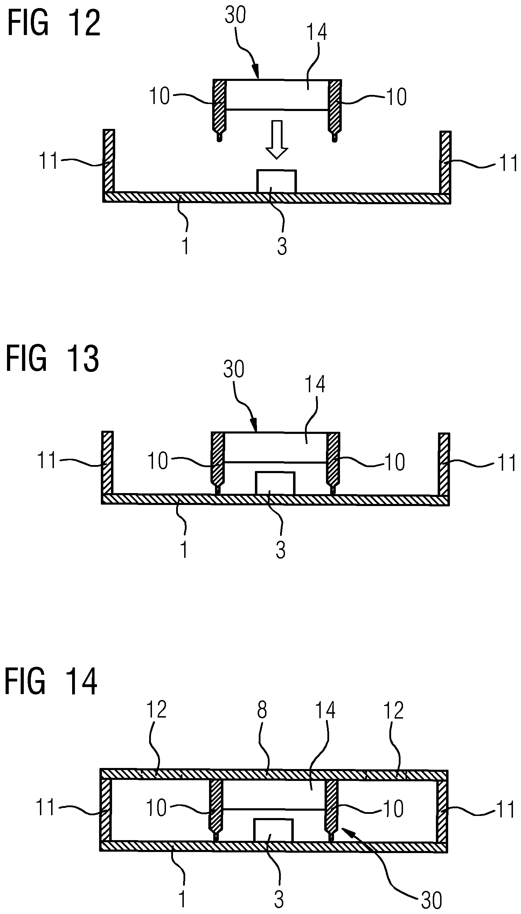

FIG 12 bis 14 zeigen ein weiteres Ausführungsbeispiel, bei dem ein eigenes mechanisches Bauteil 30 verwendet wird, welches als Kammer 15 ausbildet ist. Dieses kammerartige Bauteil 30 wird auf die Temperatursensoreinheit 3, 4, 6 aufgesetzt, siehe FIG 12 und 13, bevor der Gehäusedeckel 8 montiert wird, siehe FIG 14. Die zuvor beschriebenen Merkmale wie Einfüllöffnungen 12 für die Vergussmasse, zusätzliche Trennwand 14 für eine Unterkammer 15b für die als Anschlussstifte ausgebildeten elektrischen Leitungen 4 der Temperatursensoreinheit 3, 4 und 6 sowie das Verjüngen der Trennwände 10 an deren Kante hin zur Trägerplatte 1 können auch bei diesem separaten Kammer-Bauteil zur Anwendung kommen. Mit dem separaten Kammer-Bauteil 30 können auch bereits vorhandene Leistungsmodule nachgerüstet werden, da am Gehäusedeckel 8 keine Änderungen vorgenommen werden müssen.

## Patentansprüche

1. Leistungsmodul (9), aufweisend
- ein Gehäuse (100), umfassend eine Trägerplatte (1), Gehäusewände (11) und einen Gehäusedeckel (8),
- Halbleiterelemente (2) und eine einen Temperatursensor (3) aufweisende Temperatursensoreinheit (3, 4, 6), die im Inneren des Gehäuses (100) auf der Trägerplatte (1) angeordnet sind,
- Trennwände (10), die im Inneren des Gehäuses (100) die Temperatursensoreinheit (3, 4, 6) von den Halbleiterelementen (2) abtrennen und in einer Kammer (15) einschließen, **gekennzeichnet dadurch, dass** sich die Wandstärke der Trennwände (10) an ihrer unteren, zur Trägerplatte (1) zeigenden Kante (19) verringert.

2. Leistungsmodul (9), aufweisend
- ein Gehäuse (100), umfassend eine Trägerplatte (1), Gehäusewände (11) und einen Gehäusedeckel (8),
- Halbleiterelemente (2) und eine einen Temperatursensor (3) aufweisende Temperatursensoreinheit (3, 4, 6), die im Inneren des Gehäuses (100) auf der Trägerplatte (1) angeordnet sind,
- Trennwände (10), die im Inneren des Gehäuses (100) die Temperatursensoreinheit (3, 4, 6) von den Halbleiterelementen (2) abtrennen und in einer Kammer (15) einschließen, **gekennzeichnet dadurch, dass** die Trennwände (10) mit ihrer unteren, zur Trägerplatte (1) zeigenden Kante (19) lediglich einen schmalen Durchgangsspalt (24) zwischen den Trennwänden (10) und der Trägerplatte (1) ausbilden.

3. Leistungsmodul (9) nach Anspruch 1,
wobei die Trennwände (10) mit ihrer unteren, zur Trägerplatte (1) zeigenden Kante (19) bis an die Trägerplatte (1) heranreichen oder lediglich einen schmalen Durchgangsspalt (24) zwischen den Trennwänden (10) und der Trägerplatte (1) ausbilden.

4. Leistungsmodul (9) nach einem der vorhergehenden Ansprüche,
wobei die Trennwände (10) mit dem Gehäusedeckel (8) verbunden sind und mit dem Gehäusedeckel (8) ein Bauteil bilden.

5. Leistungsmodul (9) nach einem der Ansprüche 1-3
wobei die Trennwände (10) als ein separates Bauteil (30) ausgebildet sind, das im Inneren des Gehäuses (100) auf der Trägerplatte (1) angeordnet ist.

6. Leistungsmodul (9) nach einem der vorhergehenden Ansprüche,
wobei die Gehäusewände (11) mindestens eine Seitenwand (20) und/oder Längswand (21) aufweisen, die im Vergleich zu den restlichen Gehäusewänden (11) eine geringere Wanddicke aufweist, so dass sie im Falle eines erhöhten Drucks im Inneren des Gehäuses (100) als eine Sollbruchstelle fungieren kann.

7. Leistungsmodul (9) nach einem der vorhergehenden Ansprüche,
wobei das Leistungsmodul (9) zwei oder mehr Halbleiterelemente (2) aufweist, zwischen denen die Temperatursensoreinheit (3, 4, 6) angeordnet ist.

8. Leistungsmodul (9) nach einem der vorhergehenden Ansprüche,
wobei die Temperatursensoreinheit (3, 4, 6) elektrische Leitungen (4) zur Versorgung des Temperatursensors (3) aufweist.

9. Leistungsmodul (9) nach einem der vorhergehenden Ansprüche,
wobei die Temperatursensoreinheit (3, 4, 6) eine auf der Trägerplatte (1) liegende Leiterbahn (6) aufweist, welche eine elektrische Zuleitung zu dem Temperatursensor (3) bildet.

10. Leistungsmodul (9) nach einem der vorhergehenden Ansprüche,
wobei die Trennwände (10) mindestens eine Durchgangsöffnung (13) aufweisen, welche einen Verbindungskanal zwischen der Kammer (15) und dem restlichen Innenraum des Gehäuses (100) bildet, durch den eine elektrisch isolierende Vergussmasse in die Kammer (15) hineinfließen kann.

11. Leistungsmodul (9) nach einem der vorhergehenden Ansprüche,
wobei mindestens eine der Trennwände (10) zwei- oder mehrschichtig ausgebildet ist.

## Claims

1. Power module (9), having
- a housing (100), comprising a carrier plate (1), housing walls (11) and a housing cover (8),
- semiconductor elements (2) and a temperature sensor unit (3, 4, 6) having a temperature sensor (3) that are arranged in the interior of the housing (100) on the carrier plate (1),
- partitions (10) that, in the interior of the housing (100), separate the temperature sensor unit (3, 4, 6) from the semiconductor elements (2) and enclose said temperature sensor unit in a chamber (15),
**characterized in that** the wall thickness of the partitions (10) reduces at the lower edge (19) thereof that is facing the carrier plate (1).

2. Power module (9), having
- a housing (100), comprising a carrier plate (1), housing walls (11) and a housing cover (8),
- semiconductor elements (2) and a temperature sensor unit (3, 4, 6) having a temperature sensor (3) that are arranged in the interior of the housing (100) on the carrier plate (1),
- partitions (10) that, in the interior of the housing (100), separate the temperature sensor unit (3, 4, 6) from the semiconductor elements (2) and enclose said temperature sensor unit in a chamber (15),
**characterized in that** the partitions (10), with the lower edge (19) thereof that is facing the carrier plate (1), merely form a narrow through-gap (24) between the partitions (10) and the carrier plate (1).

3. Power module (9) according to Claim 1,
wherein the partitions (10), with the lower edge (19) thereof that is facing the
carrier plate (1), reach as far as the carrier plate (1) or merely form a narrow through-gap (24) between the partitions (10) and the carrier plate (1).

4. Power module (9) according to one of the preceding claims,
wherein the partitions (10) are connected to the housing cover (8) and form a component with the housing cover (8).

5. Power module (9) according to one of Claims 1-3,
wherein the partitions (10) are in the form of a separate component (30) that is arranged in the interior of the housing (100) on the carrier plate (1).

6. Power module (9) according to one of the preceding claims,
wherein the housing walls (11) have at least one side wall (20) and/or longitudinal wall (21) that has a smaller wall thickness in comparison to the rest of the housing walls (11), with the result that it can act as a predetermined breaking point in the event of increased pressure in the interior of the housing (100).

7. Power module (9) according to one of the preceding claims,
wherein the power module (9) has two or more semiconductor elements (2), between which the temperature sensor unit (3, 4, 6) is arranged.

8. Power module (9) according to one of the preceding claims,
wherein the temperature sensor unit (3, 4, 6) has electrical lines (4) for supplying the temperature sensor (3) with power.

9. Power module (9) according to one of the preceding claims,
wherein the temperature sensor unit (3, 4, 6) has a conductor track (6) that rests on the carrier plate (1) and forms an electrical feed line to the temperature sensor (3).

10. Power module (9) according to one of the preceding claims,
wherein the partitions (10) have at least one through-opening (13) that forms a connection channel between the chamber (15) and the rest of the interior of the housing (100), through which an electrically insulating potting compound can flow into the chamber (15).

11. Power module (9) according to one of the preceding claims,
wherein at least one of the partitions (10) has a two-layer or multi-layer design.

## Revendications

1. Module (9) de puissance comportant :
- un boîtier (100) comprenant une plaque (1) de support, des parois (11) de boîtier et un couvercle (8) de boîtier,
- des éléments (2) à semi-conducteur et une unité (3, 4, 6) à sonde de la température comportant une sonde (3) de la température, qui sont montés à l'intérieur du boîtier (100) sur la plaque (1) de support,
- des cloisons (10) qui séparent à l'intérieur du boîtier (100) l'unité (3, 4, 6) à sonde de la température des éléments (2) à semi-conducteur et les enferment dans une chambre (15),
**caractérisé en ce que** l'épaisseur de paroi des cloisons (10) diminue sur leurs bords (19) inférieurs pointant vers la plaque (1) de support.

2. Module (9) de puissance comportant :
- un boîtier (100) comprenant une plaque (1) de support, des parois (11) de boîtier et un couvercle (8) de boîtier,
- des éléments (2) à semi-conducteur et une unité (3, 4, 6) à sonde de la température comportant une sonde (3) de la température, qui sont montés à l'intérieur du boîtier (100) sur la plaque (1) de support,
- des cloisons (10), qui séparent à l'intérieur du boîtier (100) l'unité (3, 4, 6) à sonde de la température des éléments (2) à semi-conducteur et les enferment dans une chambre (15),
**caractérisé en ce que** les cloisons (10) forment par leurs bords (19) inférieurs pointant vers la plaque (1) de support seulement un intervalle (24) de passage étroit entre les cloisons (10) et la plaque (1) de support.

3. Module (9) de puissance suivant la revendication 1,
dans lequel les cloisons (10) vont, par leurs bords (19) inférieurs pointant vers la plaque (1) de support, jusqu'à la plaque (1) de support ou forment seulement un intervalle (24) de passage étroit entre les cloisons (10) et la plaque (1) de support.

4. Module (9) de puissance suivant l'une des revendications précédentes,
dans lequel les cloisons (10) sont reliées au couvercle (8) du boîtier et forment une pièce avec le couvercle (8) du boîtier.

5. Module (9) de puissance suivant l'une des revendications 1 à 3,
dans lequel les cloisons (10) forment une pièce (30) distincte, qui est montée à l'intérieur du boîtier (100) sur la plaque (1) de support.

6. Module (9) de puissance, suivant l'une des revendications précédentes,
dans lequel les parois (11) du boîtier comportent au moins une paroi (20) latérale et/ou une paroi (21) longitudinale qui a, par rapport aux autres parois (11) du boîtier, une épaisseur plus petite, de manière à pouvoir servir d'endroit destiné à se rompre dans le cas d'une élévation de la pression à l'intérieur du boîtier (100).

7. Module (9) de puissance suivant l'une des revendications précédentes,
dans lequel le module (9) de puissance a deux ou plusieurs éléments (2) à semi-conducteur entre lesquels est montée l'unité (3, 4, 6) à sonde de la température.

8. Module (9) de puissance suivant l'une des revendications précédentes,
dans lequel l'unité (3, 4, 6) à sonde de la température a des lignes (4) électriques d'alimentation de la sonde (3) de température.

9. Module (9) de puissance suivant l'une des revendications précédentes,
dans lequel l'unité (3, 4, 6) à sonde de la température a une piste (6) conductrice, qui s'applique à la plaque (1) de support et qui forme une ligne d'apport de l'électricité à la sonde (3) de la température.

10. Module (9) de puissance suivant l'une des revendications précédentes,
dans lequel les cloisons (10) ont au moins une ouverture (13) de passage, qui forme un conduit de liaison entre la chambre (15) et le reste de l'intérieur du boîtier (100), conduit, par lequel une composition de coulée isolante électriquement peut s'écouler dans la chambre (15).

11. Module (9) de puissance suivant l'une des revendications précédentes,
dans lequel au moins l'une des cloisons (10) est constituée en deux ou en plusieurs couches.
